(19) Europäisches Patentamt
European Patent Office
Office européen des brevets

(11) **EP 1 837 987 B1**

(12) **FASCICULE DE BREVET EUROPEEN**

(45) Date de publication et mention
de la délivrance du brevet:
**29.04.2009 Bulletin 2009/18**

(51) Int Cl.:
*H02P 23/14* *(2006.01)* *G01R 27/06* *(2006.01)*

(21) Numéro de dépôt: **07102694.2**

(22) Date de dépôt: **20.02.2007**

(54) **Procédé d'identification des paramètres d'un câble moteur**

Verfahren zur Parameteridentifizierung von einem Elektromotorkabel

Method of identifying the parameters of a motor cable

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **23.03.2006 FR 0651012**

(43) Date de publication de la demande:
**26.09.2007 Bulletin 2007/39**

(73) Titulaire: **Schneider Toshiba Inverter Europe SAS**
**27120 Pacy sur Eure (FR)**

(72) Inventeurs:
• **Capitaneanu, Stéfan**
**27220, Mousseaux Neuville (FR)**
• **Malrait, François**
**27120, Jouy sur Eure (FR)**
• **Jadot, Fabrice**
**27120, Pacy sur Eure (FR)**

(74) Mandataire: **Dufresne, Thierry et al**
**Schneider Electric Industries SAS**
**Service Propriété Industrielle**
**35 rue Joseph Monier - CS 30323**
**92506 Rueil-Malmaison Cedex (FR)**

(56) Documents cités:
**EP-A1- 0 648 008 EP-A1- 1 278 284**
**EP-A2- 0 421 689 US-A- 5 428 295**
**US-A1- 2005 067 991 US-B1- 6 304 472**

## Description

La présente invention se rapporte à un procédé d'identification des paramètres d'un câble électrique de puissance reliant un variateur de vitesse de type convertisseur de fréquence à une charge électrique de type moteur synchrone ou asynchrone, dans le but d'optimiser la commande du moteur électrique et de minimiser les perturbations électromagnétiques et/ou les surtensions engendrées. L'invention concerne également un variateur de vitesse capable d'identifier les paramètres d'un tel câble de puissance.

Les variateurs de vitesse de type convertisseur de fréquence comportent un onduleur de tension alimenté par une tension continue ou redressée. Cet onduleur ou hacheur comprend des composants électroniques semi-conducteurs de puissance pour hacher une tension continue en Modulation de Largeur d'Impulsion (MLI ou Pulse Width Modulation PWM). Un câble électrique de puissance (appelé aussi câble moteur) relie la sortie de l'onduleur à un moteur électrique synchrone ou asynchrone, pour fournir une tension électrique pulsée au moteur. Un dispositif de commande du variateur contrôle la conduction et le blocage des semi-conducteurs, de façon à pouvoir commander le moteur en MLI de façon appropriée. Habituellement, le variateur de vitesse est alimenté par un réseau d'alimentation électrique extérieur alternatif et comporte en entrée un redresseur et un filtre capacitif pour délivrer la tension continue à l'onduleur.

Il est connu qu'une commande en MLI d'une charge électrique est influencée par les caractéristiques du câble électrique de puissance reliant le variateur de vitesse à cette charge. Par exemple, la charge électrique subit des surtensions suite aux impulsions générées par la commande en MLI. Ces phénomènes sont d'autant plus importants que les semi-conducteurs de puissance désormais utilisés génèrent des fronts montants et descendants avec des temps de commutation très rapides.

Les surtensions sont dues aux réflexions des fronts de tension sur la charge, provoquées notamment par les ruptures d'impédance se produisant entre la charge et le câble et entre le câble et le variateur. Des surtensions répétitives subies par les enroulements d'un moteur provoquent un vieillissement prématuré des isolants et par conséquent une forte réduction de la durée de vie dudit moteur.

Les oscillations de tension sont plus particulièrement dues aux allers et retours de la propagation des fronts de tension sur le câble électrique. Ces variations de tension provoquent des perturbations électromagnétiques importantes.

Ainsi, en particulier lorsque sa longueur dépasse quelques mètres, le câble de puissance entre le variateur et le moteur peut être un élément perturbateur du point de vue de la CEM (Compatibilité Electro-Magnétique), et peut influer fortement sur la commande du moteur et contribuer à l'usure prématurée du moteur et/ou du variateur.

Il est déjà connu d'utiliser des filtres pour limiter les effets des surtensions et des perturbations. Des filtres passifs disposés du côté du moteur électrique ou du côté du variateur permettent de diminuer les surtensions causées par la longueur du câble de la ligne d'alimentation et/ou de réduire les variations de tension générées par le découpage des semi-conducteurs.

Néanmoins, pour bien adapter les filtres à l'ensemble moteur + câble et pour optimiser la commande du variateur, il est important d'identifier non seulement les paramètres du moteur mais aussi ceux du câble de puissance qui l'alimente. Les paramètres du câble utiles sont en particulier le temps de propagation et le temps d'atténuation des oscillations apparaissant sur le câble moteur suite aux fronts de tension MLI générés en permanence par le variateur. Ce temps de propagation et ce temps d'atténuation peuvent être déterminés à partir de la mesure des oscillations de tension aux bornes du moteur ou de la mesure des oscillations de courant de mode commun aux bornes du variateur.

Pour déterminer les paramètres du câble puissance, il faut donc mesurer les oscillations générées sur le câble suite aux impulsions générées par la commande en MLI. Cependant, il existe une difficulté pour obtenir des courbes de mesures significatives de ces oscillations car la période des oscillations est très faible, de l'ordre de quelques microsecondes, suivant la longueur du câble puissance (par exemple 3 μsec pour une longueur de câble de 100m). La fréquence d'échantillonnage de ces mesures doit ainsi être très élevée, ce qui nécessite des moyens coûteux, incompatibles avec des fréquences de mesure de courant/tension habituellement mises en oeuvre dans un variateur.

Un but de l'invention est donc d'obtenir une grandeur électrique représentative des oscillations survenant dans un câble moteur suite à la génération d'un échelon de tension du variateur, de façon à pouvoir déterminer les paramètres du câble permettant d'obtenir les objectifs ci-dessus.

Pour cela, l'invention décrit un procédé d'identification de paramètres d'un câble électrique reliant un variateur de vitesse à un moteur électrique. Le procédé comprend plusieurs étapes de génération espacées dans le temps, chaque étape de génération servant à la génération par le variateur d'un même échelon de tension sur le câble, plusieurs étapes de mesure, chaque étape de mesure servant au variateur à effectuer au moins une mesure d'une grandeur électrique représentative des oscillations survenant sur le câble en réponse à l'échelon généré pendant une étape de génération correspondante, chaque étape de mesure étant décalée par rapport à l'étape de génération correspondante d'une valeur égale à un multiple d'un temps de décalage prédéterminé, et une étape de traitement par le variateur servant à identifier un temps de propagation, un temps d'atténuation et une amplitude maximale desdites oscillations survenant sur le câble, à partir desdites mesures effectuées.

Selon une caractéristique, les étapes de génération s'effectuent périodiquement selon une première période et les étapes de mesure s'effectuent selon une seconde période, la première période étant inférieure à la seconde période. La première période est égale à la seconde période diminuée du temps de décalage prédéterminé.

Selon une autre caractéristique, la première période ou la seconde période est égale à la période d'échantillonnage PWM du variateur et le temps de décalage prédéterminé est égal à la période de scrutation du variateur.

Selon une autre caractéristique, le variateur effectue, durant chaque étape de mesure, plusieurs mesures d'une même grandeur électrique à des intervalles de temps fixes. La grandeur électrique mesurée est une tension aux bornes d'une phase du moteur ou est un courant de mode commun aux bornes d'une phase du variateur.

L'invention décrit également un variateur de vitesse comprenant des moyens de génération d'échelons de tension sur le câble, des moyens de mesure et une unité de traitement des mesures, de façon à mettre en oeuvre le procédé d'identification de paramètres d'un câble.

D'autres caractéristiques et avantages vont apparaître dans la description détaillée qui suit en se référant à un mode de réalisation donné à titre d'exemple et représenté par les dessins annexés sur lesquels :

- la figure 1 montre une architecture simplifiée d'un variateur de vitesse mettant en oeuvre le procédé de l'invention,
- la figure 2 est un diagramme simplifié représentant des échelons de tension périodiques et des oscillations générées par ces échelons.

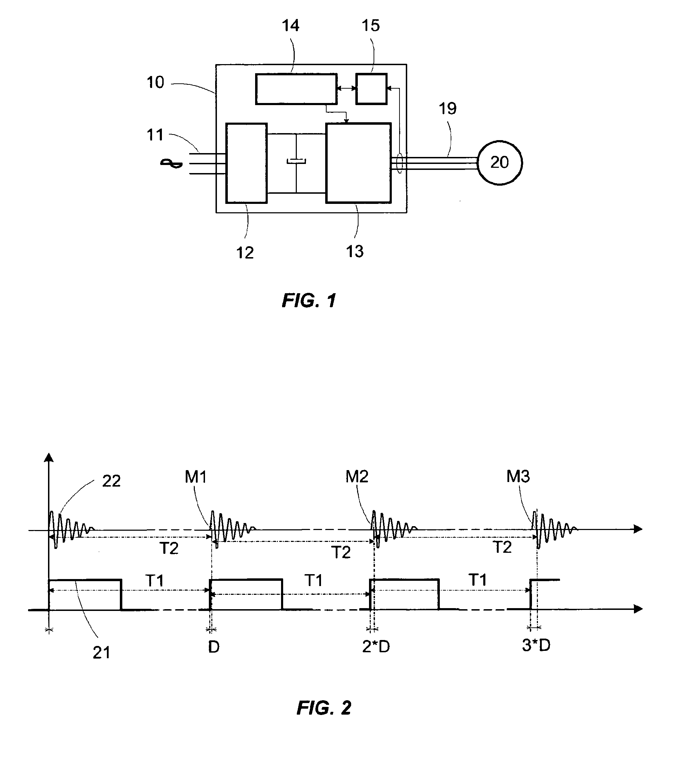

En référence au mode de réalisation schématisé en figure 1, un variateur de vitesse 10, de type convertisseur de fréquence, est alimenté par un réseau extérieur alternatif 11. Il comporte un redresseur 12 fournissant une tension continue à un onduleur 13 comportant une pluralité de composants électroniques semi-conducteurs, par exemple de type IGBT (non représentés sur la figure 1). L'onduleur 13 est piloté par une unité de traitement 14 qui commande l'allumage et l'extinction des différents composants semi-conducteurs pour commander et piloter un moteur 20. Le moteur 20 est connecté en sortie de l'onduleur 13 à l'aide d'un câble de puissance 19 (appelé aussi câble moteur 19). Le variateur 10 comporte également des moyens de mesure 15, reliés à l'unité de traitement 14 et destinés à mesurer le courant circulant dans le câble moteur 19 aux bornes du variateur 10.

Alternativement, on pourrait aussi envisager dans le cadre de la présente invention de remplacer les moyens de mesure 15 du courant aux bornes du variateur par des moyens de mesure de la tension entre phases ou entre phase et terre aux bornes du moteur 20. Cette alternative donnerait des résultats de mesure plus fiables et plus précis, mais nécessiterait des moyens de mesure déportés qui pourraient s'avérer difficiles à mettre en oeuvre en particulier si le câble moteur 19 est très long (par exemple un câble moteur d'une longueur d'un kilomètre). Ces moyens de mesure de tension devraient aussi être raccordés au variateur 10 pour exploiter l'information mesurée.

Pour corriger les perturbations susceptibles d'être provoquées par le câble moteur 19 et optimiser les réglages et les paramètres de fonctionnement du variateur, l'invention décrit un procédé permettant d'identifier rapidement les paramètres de ce câble. Ce procédé pourra notamment être mis en oeuvre durant une phase d'auto-apprentissage ou d'initiation de l'ensemble "variateur+moteur+câble" une fois le variateur raccordé au moteur via le câble puissance, et pourra être déclenché soit à l'initiative d'un opérateur, soit de façon automatique.

Dans le cadre de l'invention, les paramètres du câble moteur importants à connaître sont sa résistance linéique Ro, son inductance linéique Lo, sa capacité linéique Co et sa longueur Lc, en considérant que sa conductance linéique Go est pratiquement nulle.

Par ailleurs, il existe certains paramètres qui sont étroitement liés aux effets du câble de puissance reliant un variateur de vitesse à un moteur. Il s'agit du temps de propagation Tp et du temps d'atténuation Ta des oscillations survenant sur le câble en réponse à un échelon de tension généré par l'onduleur du variateur, ainsi que de l'amplitude maximale des oscillations de façon à obtenir le rapport X entre l'amplitude maximale des oscillations et le niveau de l'échelon de tension d'excitation généré.

Le temps de propagation Tp est défini comme étant égal le temps nécessaire à une onde pour parcourir la distance entre variateur et moteur. Ce temps est égal au quart de la période des oscillations observées sur le câble suite à un échelon de tension. Le temps d'atténuation Ta est défini par le temps mis pour que l'amplitude des oscillations passe sous les 10% de la première amplitude maximale des oscillations observées suite à un échelon de tension. Le rapport X est égal à $1 + \gamma_m$, dans lequel $\gamma_m$ représente le coefficient de réflexion du moteur.

Il est possible de démontrer que :

- 

$$Tp = Lc.\sqrt{Lo.Co}$$

- 

$$Ta = k_2.\frac{Lo}{Ro}$$

dans lequel $k_2$ est une constante qui dépend des caractéristiques du type de câble utilisé (diamètre des conducteurs, effet de peau,...). Pour simplifier la solution, il est possible de prendre pour $k_2$ une valeur approximative unique et mémorisée dans le variateur.

- 

$$Ro = \left| \frac{-\sqrt{\pi}.(2-X)\pi.k_2}{2.Lc.k_1.X.\sqrt{Ta.(Ta\pi.j + 2.k_2.Tp)}} \right|$$

dans lequel $k_1$ est une constante qui dépend des caractéristiques du type de moteur utilisé. Pour simplifier la solution, il est également possible de prendre pour $k_1$ une valeur approximative unique et mémorisée dans le variateur.

Par ailleurs, La vitesse V de propagation dans le câble est égale à :

- 

$$V = \frac{1}{\sqrt{Lo.Co}} = \frac{c}{\sqrt{\varepsilon}}$$

dans lequel c représente la vitesse de la lumière et $\varepsilon$ la permittivité électrique du câble (par exemple $\varepsilon$ = 4,5 pour un câble en cuivre). Donc, la vitesse V peut être considérée comme une constante connue.

Ainsi, la connaissance de Tp, Ta et X permet de calculer les paramètres souhaités Lc, Ro, Lo et Co, à l'aide de ces différentes équations.

Pour identifier les paramètres du câble moteur, il suffirait donc de générer un échelon de tension sur le câble, puis de mesurer les oscillations provoquées sur le câble par cet échelon de tension et de traiter les informations mesurées pour déterminer les paramètres souhaités.

Cependant, la fréquence des oscillations générées sur le câble suite à un échelon de tension est extrêmement élevée. La mesure directe des caractéristiques (amplitude, fréquence) de ces oscillations nécessiterait donc des moyens de mesure analogiques très coûteux pour être capables de travailler à des fréquences très élevées. De tels moyens de mesure ne sont pas compatibles avec les processeurs et les convertisseurs analogiques/digitaux susceptibles d'être utilisés dans un variateur de vitesse.

C'est pourquoi l'invention décrit un procédé comportant plusieurs étapes de génération successives, chaque étape de génération servant à la génération par le variateur d'un échelon de tension sur le câble. Ces étapes de génération sont espacées dans le temps selon une première période T1, comme indiqué en figure 2. L'amplitude des échelons doit être la même pour les différents échelons successifs générés à chaque étape de génération. De façon préférée, les échelons de tension sont générés simultanément sur toutes les phases du moteur, c'est-à-dire des échelons de tension de mode commun, de manière à conserver une tension moyenne nulle et donc maintenir le moteur à l'arrêt. Néanmoins, on pourrait aussi envisager de ne générer ces échelons que sur l'une des phases du moteur.

Le procédé comporte également plusieurs étapes de mesure successives, chaque étape de mesure servant au variateur de vitesse à effectuer au moins une mesure d'une grandeur électrique représentative des oscillations survenant sur le câble en réponse à un échelon généré pendant l'étape de génération correspondante.

Dans la figure 2, un graphique représente schématiquement une succession d'échelons de tension 21 appliqués au câble moteur 19 ainsi que les oscillations 22 engendrées par ces différents échelons 21 sur le câble 19. Dans cet exemple, les oscillations 22 sont détectées à l'aide d'une mesure du courant aux bornes du variateur et sont donc centrées sur la valeur zéro. Les étapes de mesures sont espacées dans le temps selon une seconde période T2 différente de T1. Chaque étape de mesure est en effet décalée par rapport à l'étape de génération correspondante d'une valeur égale à un multiple d'un temps de décalage prédéterminé D. La seconde période T2 est donc supérieure à la première période T1. De façon préférée, la période T2 est égale à la période T1 augmentée de la valeur du temps de décalage D : T2 = T1 + D.

Ainsi, la figure 2 montre qu'une étape de mesure est effectuée à un instant M1 qui est décalé d'un temps 1*D après la génération d'un échelon correspondant. Une seconde étape de mesure est effectuée à un instant M2 qui est décalé d'un temps 2*D après la génération d'un second échelon et une troisième étape de mesure est effectuée à un instant M3 qui est décalé d'un temps 3*D après la génération d'un troisième échelon.

Selon un mode de réalisation, la première période T1 est égale à la période d'échantillonnage PWM du variateur, c'est-à-dire par exemple de l'ordre de 250 $\mu$sec (micro-secondes), ce qui simplifie la génération de ces échelons. Le temps de décalage D est égal à la période de scrutation de l'unité de traitement du variateur, c'est-à-dire par exemple de l'ordre de 50 nsec (nano-secondes), soit une valeur très inférieure à T1. Selon un autre mode de réalisation, la seconde période T2 est égale à la période d'échantillonnage PWM du variateur.

Grâce aux temps de décalage variables existant entre les étapes de génération et les étapes de mesure correspondantes, on obtient ainsi une série de mesures effectuées à différents instants sur différentes courbes d'oscillations de caractéristiques identiques car générées par des échelons de tension de même niveau. Comme la période T1 est largement supérieure à la durée des oscillations générées par un échelon, le procédé aboutit à ce que les mesures effectuées lors de chaque étape de mesure permettent à l'unité de traitement 14 de reconstituer les oscillations avec une période d'échantillonnage égale à D. Ainsi, grâce à des mesures effectuées en réalité avec une période T2 de l'ordre de quelques centaines de microsecondes, on arrive à reconstituer une courbe des oscillations avec un intervalle D entre chaque point de mesure.

La succession d'étapes de génération et d'étapes de mesures se prolonge jusqu'à obtenir un nombre significatif de points de mesure, suffisant pour que l'unité de traitement puisse reconstituer la courbe des oscillations générées par un échelon avec une précision satisfaisante.

Selon une variante, chaque étape de mesure correspondant à une étape de génération peut comporter non pas une mesure M comme indiqué ci-dessus mais plusieurs mesures M, M', M". Les mesures M' et M" d'une étape de mesure donnée doivent alors être effectuées avec des intervalles de temps fixes par rapport à la première mesure M de cette même étape de mesure. Cette variante permet d'accélérer le procédé d'identification, puisque chaque étape de mesure peut alors fournir plusieurs mesures distinctes M, M' et M", ce qui réduit d'autant le nombre d'étapes de génération et de mesures nécessaires avant d'effectuer l'étape de traitement.

L'unité de traitement 14 du variateur acquiert et mémorise chaque signal de mesure transmis par les moyens de mesure 15 ainsi que l'instant auquel chaque mesure a eu lieu. Une fois l'ensemble des étapes de génération et des étapes de mesures correspondantes effectuées, l'unité de traitement 14 exécute l'étape de traitement durant laquelle elle reconstitue alors la courbe des oscillations générées par un échelon de tension, en soustrayant le temps T2 des mesures successives. Ainsi, à partir d'une fréquence de mesure T2 très inférieure à la fréquence réelle des oscillations, l'invention néanmoins permet de reconstituer de façon fiable la courbe des oscillations mesurées.

Durant l'étape de traitement, l'unité de traitement 14 effectue également différents filtrages et traitements sur les signaux mesurés, tels que par exemple une boucle PLL (Phase Locked Loop).

A partir de la courbe des oscillations mesurées obtenue, l'unité de traitement 14 identifie la période des oscillations observées pour calculer le temps de propagation Tp et identifie les amplitudes des oscillations observées pour calculer le temps d'atténuation Ta des oscillations dans le câble et pour calculer le rapport X entre l'amplitude maximale des oscillations et le niveau de l'échelon de tension d'excitation généré (voir définitions de Tp, Ta et X données précédemment).

En connaissant ces trois grandeurs Tp, Ta et X, l'unité de traitement 14 est alors capable de déterminer par calcul les paramètres Lc, Ro, Lo et Co du câble 19, grâce aux formules citées préalablement.

Ainsi, grâce au procédé d'identification décrit, les paramètres du câble puissance calculés permettent d'optimiser la commande du variateur de vitesse et d'atteindre notamment les objectifs suivants :

- adapter la commande MLI du variateur afin de réduire les surtensions potentiellement dangereuses pour le moteur, et afin de réduire les courants de fuite conduits et rayonnés, en connaissant le temps de propagation Tp et le temps d'atténuation Ta,
- préconiser l'utilisation de filtres adaptés contre les surtensions et/ou les courants de fuite (filtre CEM, sinus, dv/dt) en fonction des caractéristiques du câble, en connaissant en plus la longueur de câble Lc,
- corriger certains paramètres identifiés du moteur obtenus sans avoir tenu compte du câble de puissance (comme par exemple la résistance statorique), en connaissant en plus la longueur de câble Lc et la résistance Ro.

Il est bien entendu que l'on peut, sans sortir du cadre de l'invention telle que definie dans les revendications, imaginer d'autres variantes et perfectionnements de détail et de même envisager l'emploi de moyens équivalents.

## Revendications

1. Procédé d'identification de paramètres d'un câble électrique (19) reliant un variateur de vitesse (10) à un moteur électrique (20), **caractérisé en ce que** le procédé comprend :

   - plusieurs étapes de génération espacées dans le temps, chaque étape de génération servant à la génération par le variateur d'un même échelon de tension (21) sur le câble (19),
   - plusieurs étapes de mesure, chaque étape de mesure servant au variateur à effectuer au moins une mesure d'une grandeur électrique représentative des oscillations (22) survenant sur le câble en réponse à l'échelon (21) généré pendant une étape de génération correspondante, chaque étape de mesure étant décalée par rapport à l'étape de génération correspondante d'une valeur égale à un multiple d'un temps de décalage prédéterminé (D),
   - une étape de traitement par le variateur servant à identifier, à partir desdites mesures effectuées, une amplitude maximale desdites oscillations survenant sur le câble, un temps de propagation et un temps d'atténuation desdites oscillations survenant sur le câble.

2. Procédé d'identification selon la revendication 1, **caractérisé en ce que** les étapes de génération s'effectuent périodiquement selon une première période (T1) et les étapes de mesure s'effectuent selon une seconde période (T2), la première période (T1) étant inférieure à la seconde période (T2).

3. Procédé d'identification selon la revendication 2, **caractérisé en ce que** la première période (T1) est égale à la seconde période (T2) diminuée du temps de décalage prédéterminé (D).

4. Procédé d'identification selon la revendication 3, **caractérisé en ce que** la première période (T1) est égale à la période d'échantillonnage PWM du variateur.

5. Procédé d'identification selon la revendication 3, **caractérisé en ce que** la seconde période (T2) est égale à la période d'échantillonnage PWM du variateur.

6. Procédé d'identification selon la revendication 3, **caractérisé en ce que** le temps de décalage prédéterminé (D) est égal à la période de scrutation du variateur.

7. Procédé d'identification selon la revendication 1, **caractérisé en ce que**, durant chaque étape de mesure, le variateur effectue plusieurs mesures de la grandeur électrique à des intervalles de temps fixes.

8. Procédé d'identification selon la revendication 1, **caractérisé en ce que** la grandeur électrique mesurée est une tension aux bornes d'une phase du moteur.

9. Procédé d'identification selon la revendication 1, **caractérisé en ce que** la grandeur électrique mesurée est un courant de mode commun aux bornes d'une phase du variateur. ,

10. Procédé d'identification selon la revendication 1, **caractérisé en ce que** les échelons de tension générés durant les étapes de génération sont des échelons de tension de mode commun.

11. Procédé d'identification selon la revendication 1, **caractérisé en ce que** l'étape de traitement permet de déterminer la longueur (Lc), la résistance linéique (Ro), l'impédance linéique (Lo) et la capacité linéique (Co) du câble.

12. Variateur de vitesse destiné à la commande d'un moteur électrique (20) relié au variateur (10) par un câble électrique (19), le variateur comportant des moyens de génération (13) d'échelons de tension sur le câble, des moyens de mesure (15) et une unité de traitement (14) des mesures, **caractérisé en ce que** :

 - les moyens de génération effectuent plusieurs étapes de génération espacées dans le temps, chaque étape de génération servant à générer un même échelon de tension (21) sur le câble,
 - les moyens de mesure effectuent plusieurs étapes de mesure, chaque étape de mesure servant à effectuer au moins une mesure d'une grandeur électrique représentative des oscillations (22) survenant sur le câble en réponse à l'échelon généré pendant une étape de génération correspondante, chaque étape de mesure étant décalée par rapport à l'étape de génération correspondante d'une valeur égale à un multiple d'un temps de décalage prédéterminé (D),
- l'unité de traitement identifie une amplitude maximale desdites oscillations survenant sur le câble, un temps de propagation et un temps d'atténuation desdites oscillations survenant sur le câble, à partir desdites mesures effectuées.

13. Variateur de vitesse selon la revendication 12, **caractérisé en ce que** les étapes de génération s'effectuent périodiquement selon une première période (T1) et les étapes de mesure s'effectuent selon une seconde période (T2), la première période étant inférieure à la seconde période.

14. Variateur de vitesse selon la revendication 13, **caractérisé en ce que** la première période (T1) est égale à la seconde période (T2) diminuée du temps de décalage prédéterminé (D).

15. Variateur de vitesse selon la revendication 14, **caractérisé en ce que** la première période est égale à la période d'échantillonnage PWM du variateur.

16. Variateur de vitesse selon la revendication 14, **caractérisé en ce que** la seconde période est égale à la période d'échantillonnage PWM du variateur.

17. Variateur de vitesse selon la revendication 14, **caractérisé en ce que** le temps de décalage prédéterminé est égal à la période de scrutation du variateur.

18. Variateur de vitesse selon la revendication 12, **caractérisé en ce que**, durant chaque étape de mesure, le variateur effectue plusieurs mesures de la grandeur électrique à des intervalles de temps fixes.

19. Variateur de vitesse selon la revendication 12, **caractérisé en ce que** la grandeur électrique mesurée est une tension aux bornes d'une phase du moteur.

20. Variateur de vitesse selon la revendication 12, **caractérisé en ce que** la grandeur électrique mesurée est un courant de mode commun aux bornes d'une phase du variateur.

21. Variateur de vitesse selon la revendication 12, **caractérisé en ce que** les échelons de tension générés sont des échelons de tension de mode commun.

22. Variateur de vitesse selon la revendication 12, **caractérisé en ce que** l'unité de traitement calcule la longueur (Lc), la résistance linéique (Ro), l'impédance linéique (Lo) et la capacité linéique (Co) du câble.

## Claims

1. Method for identifying parameters of an electric cable (19) linking a variable speed drive (10) to an electric motor (20), **characterized in that** the method comprises:

   - a number of generation steps spaced in time, each generation step being used for the generation, by the speed drive, of an identical voltage level (21) on the cable (19),
   - a number of measurement steps, each measurement step enabling the speed drive to perform at least one measurement of an electrical quantity representative of oscillations (22) occurring on the cable in response to the level (21) generated during a corresponding generation step, each measurement step being offset relative to the corresponding generation step by a value equal to a multiple of a predetermined offset time (D),
   - a processing step, by the speed drive, being used to identify, from said measurements performed, a maximum amplitude of said oscillations occurring on the cable, a propagation time and an attenuation time of said oscillations occurring on the cable.

2. Identification method according to Claim 1, **characterized in that** the generation steps are performed periodically according to a first period (T1) and the measurement steps are performed according to a second period (T2), the first period (T1) being less than the second period (T2).

3. Identification method according to Claim 2, **characterized in that** the first period (T1) is equal to the second period (T2) minus the predetermined offset time (D).

4. Identification method according to Claim 3, **characterized in that** the first (T1) is equal to the sampling period PWM of the speed drive.

5. Identification method according to Claim 3, **characterized in that** the second period (T2) is equal to the sampling period PWM of the speed drive.

6. Identification method according to Claim 3, **characterized in that** the predetermined offset time (D) is equal to the scanning period of the speed drive.

7. Identification method according to Claim 1, **characterized in that,** during each measurement step, the speed drive performs a number of measurements of the electrical quantity at fixed time intervals.

8. Identification method according to Claim 1, **characterized in that** the measured electrical quantity is a voltage at the terminals of a phase of the motor.

9. Identification method according to Claim 1, **characterized in that** the measured electrical quantity is a common mode current at the terminals of a phase of the speed drive.

10. Identification method according to Claim 1, **characterized in that** the voltage levels generated during the generation steps are common mode voltage levels.

11. Identification method according to Claim 1, **characterized in that** the processing step can be used to determined the length (Lc), the resistance per unit length (Ro), the impedance per unit length (Lo) and the capacitance per unit length (Co) of the cable.

12. Variable speed drive intended for the control of an electric motor (20) linked to the speed drive (10) by an electric cable (19), the speed drive comprising means (13) for generating voltage levels on the cable, measurement means (15) and a measurement processing unit (14), **characterized in that:**

    - the generation means perform a number of generation steps spaced in time, each generation step being used to generate an identical voltage level (21) on the cable,
    - the measurement means perform a number of measurement steps, each measurement step being used to perform at least one measurement of an electrical quantity representative of oscillations (22) occurring on the cable in response to the level generated during a corresponding generation step, each measurement step being offset relative to the corresponding generation step by a value equal to a multiple of a predetermined offset time (D),
    - the processing unit identifies a maximum amplitude of said oscillations occurring on the cable, a propagation time and an attenuation time of said oscillations occurring on the cable, from said measurements performed.

13. Variable speed drive according to Claim 12, **characterized in that** the generation steps are performed periodically according to a first period (T1) and the measurement steps are performed according to a second period (T2), the first period being less than the second period.

14. Variable speed drive according to Claim 13, **char-**

**acterized in that** the first period (T1) is equal to the second period (T2) minus the predetermined offset time (D).

15. Variable speed drive according to Claim 14, **characterized in that** the first period is equal to the sampling period PWM of the speed drive.

16. Variable speed drive according to Claim 14, **characterized in that** the second period is equal to the sampling period PWM of the speed drive.

17. Variable speed drive according to Claim 14, **characterized in that** the predetermined offset time is equal to the scanning period of the speed drive.

18. Variable speed drive according to Claim 12, **characterized in that,** during each measurement step, the speed drive performs a number of measurements of the electrical quantity at fixed time intervals.

19. Variable speed drive according to Claim 12, **characterized in that** the measured electrical quantity is a voltage at the terminals of a phase of the motor.

20. Variable speed drive according to Claim 12, **characterized in that** the measured electrical quantity is a common mode current at the terminals of a phase of the speed drive.

21. Variable speed drive according to Claim 12, **characterized in that** the voltage levels generated are common mode voltage levels.

22. Variable speed drive according to Claim 12, **characterized in that** the processing unit calculates the length (Lc), the resistance per unit length (Ro), the impedance per unit length (Lo) and the capacitance per unit length (Co) of the cable.

**Patentansprüche**

1. Verfahren zur Identifizierung von Parametern eines Elektrokabels (19), das einen Umrichter (10) mit einem Elektromotor (20) verbindet, **dadurch gekennzeichnet, dass** das Verfahren aufweist:

   - mehrere zeitlich beabstandete Erzeugungsschritte, wobei jeder Erzeugungsschritt zur Erzeugung einer gleichen Spannungsstufe (21) auf dem Kabel (19) durch den Umrichter dient,
   - mehrere Messschritte, wobei jeder Messschritt dem Umrichter dazu dient, mindestens eine Messung einer elektrischen Größe durchzuführen, die für die Schwingungen (22) repräsentativ ist, die auf dem Kabel als Reaktion auf die während eines entsprechenden Erzeugungsschritts erzeugte Stufe (21) auftreten, wobei jeder Messschritt bezüglich des entsprechenden Erzeugungsschritts um einen Wert verschoben ist, der gleich einem Vielfachen einer vorbestimmten Verschiebungszeit (D) ist,
   - einen Schritt der Verarbeitung durch den Umrichter, der dazu dient, ausgehend von den durchgeführten Messungen eine maximale Amplitude der auf dem Kabel auftretenden Schwingungen, eine Ausbreitungszeit und eine Dämpfungszeit der auf dem Kabel auftretenden Schwingungen zu identifizieren.

2. Identifizierungsverfahren nach Anspruch 1, **dadurch gekennzeichnet, dass** die Erzeugungsschritte periodisch gemäß einer ersten Periode (T1) und die Messschritte gemäß einer zweiten Periode (T2) durchgeführt werden, wobei die erste Periode (T1) kürzer als die zweite Periode (T2) ist.

3. Identifizierungsverfahren nach Anspruch 2, **dadurch gekennzeichnet, dass** die erste Periode (T1) gleich der zweiten Periode (T2) verringert um die vorbestimmte Verschiebungszeit (D) ist.

4. Identifizierungsverfahren nach Anspruch 3, **dadurch gekennzeichnet, dass** die erste Periode (T1) gleich der Tastperiode PWM des Umrichters ist.

5. Identifizierungsverfahren nach Anspruch 3, **dadurch gekennzeichnet, dass** die zweite Periode (T2) gleich der Tastperiode PWM des Umrichters ist.

6. Identifizierungsverfahren nach Anspruch 3, **dadurch gekennzeichnet, dass** die vorbestimmte Verschiebungszeit (D) gleich der Abfrageperiode des Umrichters ist.

7. Identifizierungsverfahren nach Anspruch 1, **dadurch gekennzeichnet, dass** der Umrichter während jedes Messschritts mehrere Messungen der elektrischen Größe in festen Zeitintervallen durchführt.

8. Identifizierungsverfahren nach Anspruch 1, **dadurch gekennzeichnet, dass** die gemessene elektrische Größe eine Spannung an den Klemmen einer Phase des Motors ist.

9. Identifizierungsverfahren nach Anspruch 1, **dadurch gekennzeichnet, dass** die gemessene elektrische Größe ein Gleichtaktstrom an den Klemmen einer Phase des Umrichters ist.

10. Identifizierungsverfahren nach Anspruch 1, **dadurch gekennzeichnet, dass** die während der Erzeugungsphase erzeugten Spannungsstufen Gleichtakt-Spannungsstufen sind.

**11.** Identifizierungsverfahren nach Anspruch 1, **dadurch gekennzeichnet, dass** der Verarbeitungsschritt es ermöglicht, die Länge (Lc), den linearen Widerstand (Ro), die lineare Impedanz (Lo) und die lineare Kapazität (Co) des Kabels zu bestimmen.

**12.** Umrichter, der zur Steuerung eines Elektromotors (20) bestimmt ist, welcher mit dem Umrichter (10) über ein Elektrokabel (19) verbunden ist, wobei der Umrichter Einrichtungen zur Erzeugung (13) von Spannungsstufen auf dem Kabel, Messeinrichtungen (15) und eine Verarbeitungseinheit (14) der Messungen aufweist, **dadurch gekennzeichnet, dass:**

- die Erzeugungseinrichtungen mehrere zeitlich beabstandete Erzeugungsschritte durchführen, wobei jeder Erzeugungsschritt dazu dient, die gleiche Spannungsstufe (21) auf dem Kabel zu erzeugen,
- die Messeinrichtungen mehrere Messschritte durchführen, wobei jeder Messschritt dazu dient, mindestens eine Messung einer elektrischen Größe durchzuführen, die für die Schwingungen (22) repräsentativ ist, die auf dem Kabel als Reaktion auf die während eines entsprechenden Erzeugungsschritts erzeugte Stufe auftreten, wobei jeder Messschritt bezüglich des entsprechenden Erzeugungsschritts um einen Wert verschoben ist, der gleich einem Vielfachen einer vorbestimmten Verschiebungszeit (D) ist,
- die Verarbeitungseinheit eine maximale Amplitude der auf dem Kabel auftretenden Schwingungen, eine Ausbreitungszeit und eine Dämpfungszeit der auf dem Kabel auftretenden Schwingungen ausgehend von den durchgeführten Messungen identifiziert.

**13.** Umrichter nach Anspruch 12, **dadurch gekennzeichnet, dass** die Erzeugungsschritte periodisch gemäß einer ersten Periode (T1) und die Messschritte gemäß einer zweiten Periode (T2) durchgeführt werden, wobei die erste Periode kürzer als die zweite Periode ist.

**14.** Umrichter nach Anspruch 13, **dadurch gekennzeichnet, dass** die erste Periode (T1) gleich der zweiten Periode (T2) verringert um die vorbestimmte Verschiebungszeit (D) ist.

**15.** Umrichter nach Anspruch 14, **dadurch gekennzeichnet, dass** die erste Periode gleich der Tastperiode PWM des Umrichters ist.

**16.** Umrichter nach Anspruch 14, **dadurch gekennzeichnet, dass** die zweite Periode gleich der Tastperiode PWM des Umrichters ist.

**17.** Umrichter nach Anspruch 14, **dadurch gekennzeichnet, dass** die vorbestimmte Verschiebungszeit gleich der Abfrageperiode des Umrichters ist.

**18.** Umrichter nach Anspruch 12, **dadurch gekennzeichnet, dass** der Umrichter während jedes Messschritts mehrere Messungen der elektrischen Größe in festen Zeitintervallen durchführt.

**19.** Umrichter nach Anspruch 12, **dadurch gekennzeichnet, dass** die gemessene elektrische Größe eine Spannung an den Klemmen einer Phase des Motors ist.

**20.** Umrichter nach Anspruch 12, **dadurch gekennzeichnet, dass** die gemessene elektrische Größe ein Gleichtaktstrom an den Klemmen einer Phase des Umrichters ist.

**21.** Umrichter nach Anspruch 12, **dadurch gekennzeichnet, dass** die erzeugten Spannungsstufen Gleichtakt-Spannungsstufen sind.

**22.** Umrichter nach Anspruch 12, **dadurch gekennzeichnet, dass** die Verarbeitungseinheit die Länge (Lc), den linearen Widerstand (Ro), die lineare Impedanz (Lo) und die lineare Kapazität (Co) des Kabels berechnet.

**FIG. 1**

**FIG. 2**